# EUROPEAN PATENT APPLICATION

(11) **EP 4 791 152 A1**
(43) Date of publication of application: **12.08.2026**
(21) Application number: 25221122.2
(22) Date of filing: 05.12.2025
(51) Int. Cl.: H10F 39/00

(54) **IMAGE SENSOR, METHOD OF MANUFACTURING THE SAME, AND ELECTRONIC DEVICE INCLUDING THE IMAGE SENSOR**

(30) Priority: 07.02.2025 KR 20250016173
(71) Applicant: Samsung Electronics Co., Ltd., Suwon-si, Gyeonggi-do 16677 (KR)
(72) Inventor: PARK, Hyeonsoo, 16677 Suwon-si (KR); ROH, Sookyoung, 16678 Suwon-si (KR); PARK, Hyunsung, 16678 Suwon-si (KR); PARK, Hongkyu, 16678 Suwon-si (KR)
(74) Representative: Elkington and Fife LLP

(57) **Abstract**

An image sensor includes an active pixel sensor region configured to output a pixel signal for image generation, and a periphery region at an edge of the active pixel sensor region. The active pixel sensor region and the periphery region may include a sensor substrate, and the sensor substrate may include a plurality of pixels arranged across the active pixel sensor region and the periphery region. The active pixel sensor region may include a plurality of nanostructures disposed to face the sensor substrate and spaced apart from the sensor substrate, the periphery region may include a light-shielding layer disposed on the sensor substrate and at the edge of the active pixel sensor region, and the light-shielding layer may include a light-reflective layer and a light-absorbing layer including an inorganic material.

## Description

### FIELD OF THE INVENTION

The disclosure relates to an image sensor and an electronic device including the image sensor.

### BACKGROUND OF THE INVENTION

Image sensors sense light incident from an object and convert the sensed light into an electrical signal for obtaining an image of the object.

In general, image sensors use color filters to distinguish and detect the colors of incident light. However, color filters absorb colors of light other than corresponding colors and may thus reduce light utilization efficiency. Accordingly, in recent years, image sensors that use meta-optical elements configured to distinguish and detect the colors of incident light, instead of using color filters, have been proposed.

Such an image sensor includes an active region that senses light and a periphery region that surrounds the active region. The active region may include color filters or meta-optical structures for distinguishing the colors of light incident from an object. The periphery region may include various circuit elements and wirings for signal processing, and may further include a light-blocking material to prevent light from entering the active region from the various circuit elements and wirings.

Methods of effectively blocking light in the periphery region have been researched to improve the quality of images formed in the active region.

### SUMMARY OF THE INVENTION

One or more embodiments provide an image sensor including a light-shielding layer, a method of manufacturing the image sensor, and an electronic device including the image sensor.

Additional aspects will be set forth in part in the description which follows and, in part, will be apparent from the description, or may be learned by practice of the presented embodiments of the disclosure.

According to an aspect of the disclosure, an active pixel sensor region configured to output a pixel signal for image generation; and a periphery region at an edge of the active pixel sensor region, wherein the active pixel sensor region and the periphery region may include a sensor substrate, and the sensor substrate may include a plurality of pixels arranged across the active pixel sensor region and the periphery region, the active pixel sensor region may include a plurality of nanostructures disposed to face the sensor substrate and spaced apart from the sensor substrate, the periphery region may include a light-shielding layer disposed on the sensor substrate and at the edge of the active pixel sensor region, and the light-shielding layer may include a light-reflective layer and a light-absorbing layer including an inorganic material.

Embodiments of the invention concern an image sensor architecture in which the periphery region incorporates a composite light-shielding layer formed of a light-reflective layer and light-absorbing layer. The structure may suppress stray light ingress from peripheral circuitry into an active pixel region that employs a meta-optical element for wavelength-selective light splitting. The approach may enhance black-level accuracy and reduces flare artefacts, particularly in sensors utilizing nanostructured metasurfaces in place of conventional colour filters.

A core concept lies in the combination of a reflective metal underlayer and an inorganic light-absorbing layer-preferably amorphous carbon, optionally doped or alloyed (e.g., a-CxSi(1-x), a-CxSi(1-x)N)-disposed in the optical black/periphery region. This material system is selected for its tunable refractive index, density (2-3 g/cm³) and high broadband optical absorption, enabling effective suppression of both direct and oblique incident light. The specification demonstrates that appropriate thickness control (10 nm-2 µm) allows optimization of reflectance across the visible spectrum while maintaining thermal stability and manufacturability. Intermediate or upper refractive-index-matching layers may be incorporated to mitigate multi-reflection interfaces with planarization layers.

Functionally, the periphery structure blocks light propagation paths that otherwise bypass the meta-optical element and reach peripheral pixels. The amorphous-carbon layer provides strong absorption, while the reflective base layer prevents transmission into underlying periphery metallisation or TSV structures. Optional integration of a blue-filter layer further suppresses long-wavelength components prone to scattering into the active array. These combined effects stabilise dark-signal output, improve optical black calibration, and mitigate peripheral flare that is especially problematic in metasurface-based sensors where long-wavelength stray paths are more difficult to control.

The proposed manufacturing approach is compatible with CMOS sensor processes and allows the light-shielding stack to be deposited across the full wafer prior to selective removal from the active pixel region. PECVD, sputtering and RMS deposition techniques accommodate the required carbon-film properties, and post-deposition annealing enables tuning of sp²/sp³ proportions to meet absorption and thermal-reliability targets. The architecture integrates cleanly with planarisation, etch-stop, dielectric and anti-reflection layers that extend continuously across active and peripheral regions, thereby avoiding topography discontinuities that would compromise metasurface fabrication.

At system level, embodiments may be readily applicable to high-resolution CMOS image sensors used in mobile and multi-camera modules, including folded-optics systems. The controlled peripheral light-blocking improves pixel-to-pixel uniformity, dynamic range, and colour-purity when combined with or without conventional CFA layers.

The light-absorbing layer may have a thickness of 10 nm to 2 µm.

The light-absorbing layer may have a density of 2 g/cm³ to 3 g/cm³.

The light-absorbing layer may include an a-CₓSi₍₁₋ₓ₎ alloy or a-CₓSi₍₁₋ₓ₎N.

The inorganic material may be amorphous carbon. The light-absorbing layer may further include a dopant with which the amorphous carbon is doped.

The light-reflective layer may include a metal.

The light-reflective layer and the light-absorbing layer of the light-shielding layer may be sequentially disposed on the sensor substrate.

The light-reflective layer may be in direct contact with the light-absorbing layer.

The light-shielding layer may further include an intermediate additional layer disposed between the light-reflective layer and the light-absorbing layer and having a refractive index that is different from a refractive index of the light-absorbing layer.

The active pixel sensor region may include the meta-optical element in which the plurality of nanostructures is positioned. The active pixel sensor region may further include a color filter array layer disposed between the sensor substrate and the meta-optical element.

The light-shielding layer may further include a blue filter material layer disposed on the light-absorbing layer.

The image sensor may further include a planarization layer extending from the active pixel sensor region to the periphery region and covering the color filter array layer and the light-shielding layer.

The light-shielding layer may further include an upper additional layer disposed on the blue filter material layer and having a refractive index that is different from a refractive index of the planarization layer.

According to another aspect of the disclosure, a method of manufacturing an image sensor includes forming a sensor substrate including a plurality of pixels configured to sense light, setting regions of the sensor substrate as an active pixel sensor region and a periphery region at an edge of the active pixel sensor region, forming a light-shielding layer including a light-reflective layer and a light-absorbing layer on the sensor substrate in the periphery region, forming a planarization layer on the sensor substrate, the planarization layer extending from the active pixel sensor region to the periphery region and covering the light-shielding layer, and forming a plurality of nanostructures on the planarization layer in the active pixel sensor region, wherein the forming of the light-shielding layer includes forming the light-reflective layer, and forming the light-absorbing layer including an inorganic material on the light-reflective layer.

The forming of the light-shielding layer may include forming the light-shielding layer on the sensor substrate across the active pixel sensor region and the periphery region, and removing the light-shielding layer from the active pixel sensor region.

The forming of the light-shielding layer may further include annealing the light-absorbing layer after forming the light-absorbing layer.

The light-absorbing layer may have a thickness of 10 nm to 2 µm, and the light-absorbing layer may have a density of 2 g/cm³ to 3 g/cm³.

The light-absorbing layer may include an a-CₓSi₍₁₋ₓ₎ alloy or a-CₓSi₍₁₋ₓ₎N.

The forming of the light-absorbing layer may be performed by plasma-enhanced chemical vapor deposition (PECVD), magnetron sputtering (MS), rotary target magnetron sputtering (RMS), or sputtering.

According to another aspect of the disclosure, an electronic device includes a lens assembly configured to form an optical image of an object, and an image sensor configured to convert the optical image into an electrical signal. The image sensor includes an active pixel sensor region outputting a pixel signal for image generation, and a periphery region surrounding the active pixel sensor region. The active pixel sensor region and the periphery region include a sensor substrate including a plurality of pixels arranged across the active pixel sensor region and the periphery region. The active pixel sensor region includes a plurality of nanostructures disposed to face the sensor substrate and spaced apart from the sensor substrate. The periphery region includes a light-shielding layer disposed on the sensor substrate and at the edge of the active pixel sensor region. The light-shielding layer includes a light-reflective layer including a light-reflecting material and a light-absorbing layer including an inorganic material.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram illustrating an image sensor according to one or more embodiments;
FIG. 2 is a plan view illustrating an example arrangement of a plurality of regions of an image sensor that have different functions, according to one or more embodiments;
FIG. 3 is a cross-sectional view of the image sensor, taken along line A-A' of FIG. 2;
FIG. 4 is a cross-sectional view illustrating a structure of a light-shielding layer that may be provided in an image sensor, according to one or more embodiments;
FIG. 5 is a graph illustrating wavelength-dependent reflection spectra by a light-shielding layer provided in an image sensor according to one or more embodiments, for various thicknesses of amorphous carbon;
FIG. 6 is a graph illustrating the reflectance of the light-shielding layer provided in the image sensor according to one or more embodiments, with respect to the thickness of the amorphous carbon for various light incidence angles;
FIG. 7 is a cross-sectional view illustrating a light-shielding layer that may be provided in an image sensor, according to one or more embodiments;
FIG. 8 is a cross-sectional view illustrating a light-shielding layer that may be provided in an image sensor, according to one or more embodiments;
FIG. 9 is a cross-sectional view illustrating a light-shielding layer that may be provided in an image sensor, according to one or more embodiments;
FIG. 10 is a cross-sectional view illustrating an image sensor according to one or more embodiments.
FIGS. 11A and 11B are cross-sectional views illustrating a light-shielding layer that may be provided in the image sensor shown in FIG. 10;
FIG. 12 is a flowchart schematically illustrating a method of manufacturing an image sensor, according to one or more embodiments;
FIG. 13 is a block diagram schematically illustrating an electronic device including an image sensor, according to one or more embodiments;
FIG. 14 is a block diagram schematically illustrating a camera module provided in the electronic device shown in FIG. 13;
FIG. 15 is a block diagram illustrating an electronic device including multiple camera modules; and
FIG. 16 is a block diagram illustrating a camera module of the electronic device shown in FIG. 15.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described with reference to the accompanying drawings. The embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on the other element while making contact with the other element or may be above the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" and/or "comprising" used herein specify the presence of stated features or elements, but do not preclude the presence or addition of one or more other features or elements.

In the present disclosure, terms such as "unit" or "module" may be used to denote a unit that has at least one function or operation and is implemented with hardware, software, or a combination of hardware and software.

An element referred to with the "definite article" or a demonstrative determiner may be construed as the element or the elements even though it has a singular form.

Operations of a method may be performed in appropriate order unless explicitly described in terms of order or described to the contrary. In addition, examples or terms (for example, "such as" and "etc.") are used for the purpose of description and are not intended to limit the scope of the disclosure unless defined by the claims.

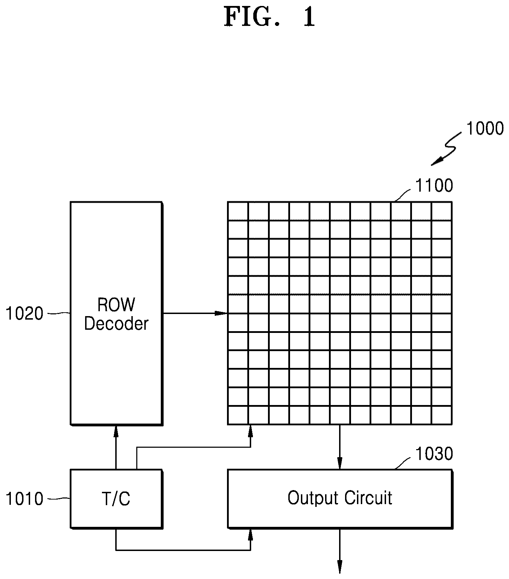

FIG. 1 is a block diagram schematically illustrating an image sensor 1000 according to one or more embodiments.

Referring to FIG. 1, the image sensor 1000 may include a pixel array 1100, a timing controller 1010, a row decoder 1020, and an output circuit 1030. The image sensor 1000 may be a charge-coupled device (CCD) image sensor or a complementary metal-oxide-semiconductor (CMOS) image sensor.

The pixel array 1100 may include pixels arranged two-dimensionally in a plurality of rows and a plurality of columns. The row decoder 1020 may select one of the rows of the pixel array 1100 in response to a row address signal output from the timing controller 1010. The output circuit 1030 may output photodetection signals in units of columns from a plurality of pixels arranged in the selected row. To this end, the output circuit 1030 may include a column decoder and an analog-to-digital converter (ADC). For example, the output circuit 1030 may include a plurality of ADCs arranged respectively for the columns between the column decoder and the pixel array 1100, or may include a single ADC disposed at an output terminal of the column decoder. The timing controller 1010, the row decoder 1020, and the output circuit 1030 may be implemented on a single chip or separate chips. A processor for processing image signals output through the output circuit 1030 may also be implemented on the same chip together with the timing controller 1010, the row decoder 1020, and the output circuit 1030.

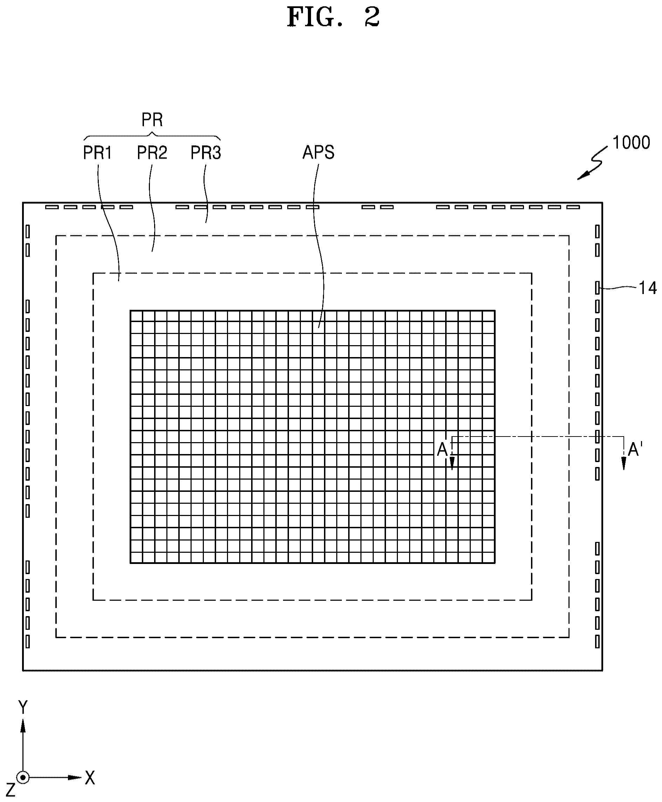

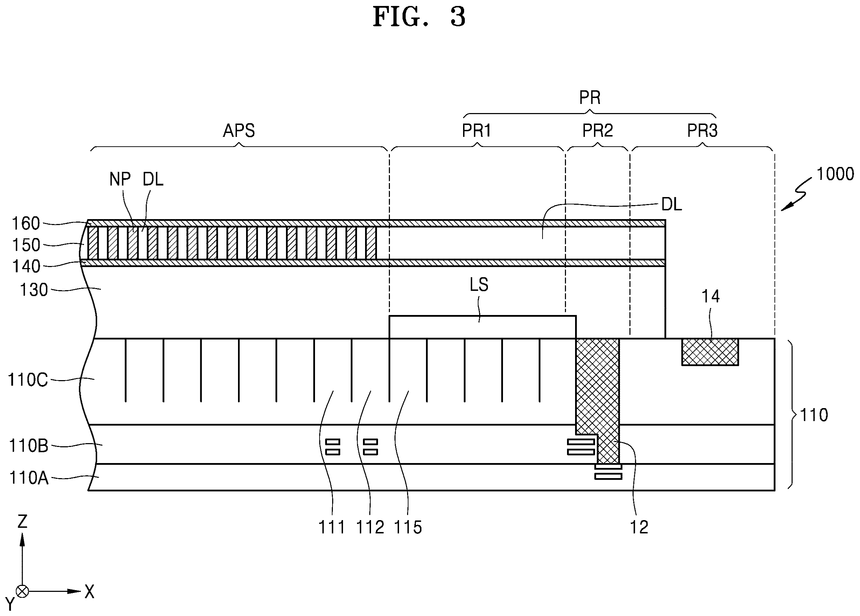

The image sensor 1000 may be divided into a plurality of regions having different functions and/or different structures. FIG. 2 is a plan view illustrating an example arrangement of a plurality of regions of an image sensor 1000 that have different functions and/or different structures, according to one or more embodiments. FIG. 3 is a cross-sectional view of the image sensor 1000, taken along line A-A' of FIG. 2.

Referring to FIGS. 2 and 3, the image sensor 1000 may include an active pixel sensor region APS configured to output a pixel signal for generating an image, and a periphery region PR surrounding the active pixel sensor region APS. The periphery region PR may include a plurality of regions. For example, the periphery region PR may include an optical black region PR1 surrounding the active pixel sensor region APS and configured to output a dark signal, a back-via-stack region PR2 surrounding the optical black region PR1 and including wires for electrical connections between upper and lower layers in the image sensor 1000, and a contact pad region PR3 surrounding the back-via-stack region PR2 and including contact pads 14 for signal input/output with the outside of the image sensor 1000. While FIG. 2 illustrates that the periphery region PR surrounds the active pixel sensor region APS, the arrangement of the periphery region PR is not limited to this configuration. For example, the periphery region PR may be positioned at one or more edges of the active pixel sensor region APS and/or around the active pixel sensor region APS. The periphery region PR may surround the active pixel sensor region APS in various ways, including fully enclosing its outer boundary or only partially extending around it.

In the present disclosure, the term "surround" is used broadly to encompass both narrow and expansive configurations. It includes instances where the periphery region PR entirely encloses the active pixel sensor region APS, as well as cases where it partially encircles or is positioned adjacent to one or more sides of the active pixel sensor region APS.

The active pixel sensor region APS may refer to a region in which pixels outputting signals directly used for image generation are formed. The active pixel sensor region APS may correspond to the pixel array 1100 shown in FIG. 1. The active pixel sensor region APS may be provided in the center portion of the image sensor 1000. Some or all of the pixels included in the active pixel sensor region APS may detect a specific wavelength band (i.e., a specific color component) of light incident on the active pixel sensor region APS, and may output the intensity of the color component of the incident light. The active pixel sensor region APS may include three or more types of pixels. For example, the active pixel sensor region APS may include green pixels configured to detect the intensity of a green light component of incident light, red pixels configured to detect the intensity of a red light component of incident light, and blue pixels configured to detect the intensity of a blue light component of incident light. The image sensor 1000 may generate an image using signals output from the pixels arranged in the active pixel sensor region APS, and as the number of pixels included in the active pixel sensor region APS increases, the image sensor 1000 may generate images with a higher resolution. A nanostructured layer (e.g., a meta-optical element 150) may be positioned above the active pixel sensor region APS, enabling selective separation of light by wavelength to split color signals. The image sensor 1000 may not include a color filter or may only partially include a color filter, and an inorganic material such as amorphous carbon may be provided as a light-shield layer LS to surround the active pixel sensor region APS.

The optical black region PR1 is a region on the image sensor that is shielded from light. Pixels in the optical black region PR1 may output electrical signals, referred to as dark signals, in the absence of incident light. The image sensor 1000 may use the dark signals to determine a baseline signal level and to enable black level correction by subtracting the baselines signal level from an actual image data received from pixels located in the active pixel sensor region APS. The optical black region PR1 may surround the active pixel sensor region APS. A light-shielding layer LS for blocking incident light may be disposed in the optical black region PR1, and the light-shielding layer LS may surround the active pixel sensor region APS. The optical black region PR1, like the active pixel sensor region APS, includes pixels configured to detect light, but due to the light-shielding layer LS that blocks light incident on the pixels, the pixels in the optical black region PR1 do not output pixel signals for image generation. In a state in which incident light is blocked, the pixels arranged in the optical black region PR1 may output dark signals that are noise signals generated due to materials of photodiodes or structures of the pixels. The dark signals may be used as reference signals for compensating for noises of pixel signals output from the active pixel sensor region APS.

The back-via-stack region PR2 may include a plurality of back via stacks 12 for electrical connections between upper and lower layers within the image sensor 1000. The back-via-stack region PR2 may surround the optical black region PR1. The back via stacks 12 may be arranged in the back-via-stack region PR2 at a distance from the optical black region PR1. The back via stacks 12 may be provided not only in the cross-section A-A' shown in FIG. 2 but also at other positions. Each of the back via stacks 12 may have a shape extending longitudinally in a first direction (i.e., an X-direction or a first horizontal direction) or a second direction (i.e., a Y-direction or a second horizontal direction) while facing one side of the optical black region PR1. Alternatively, the back via stacks 12 may be arranged at intervals in the first direction or the second direction.

The contact pad region PR3 may include the contact pads 14 for signal input/output between the image sensor 1000 and an external device. The contact pad region PR3 may surround the back-via-stack region PR2. The number and positions of the contact pads 14 are not limited to those shown in the drawings and may be variously selected according to design requirements. The contact pads 14 may be electrically connected to input/output circuits provided in the image sensor 1000.

Referring to FIG. 3, the active pixel sensor region APS and the periphery region PR (e.g., the optical black region PR1, the back-via-stack region PR2, and the contact pad region PR3) may commonly include a sensor substrate 110. In other words, the sensor substrate 110 may extend across the active pixel sensor region APS, the optical black region PR1, the back-via-stack region PR2, and the contact pad region PR3. Inside the sensor substrate 110 and on an upper surface of the sensor substrate 110, the active pixel sensor region APS, the optical black region PR1, the back-via-stack region PR2, and the contact pad region PR3 may have different layer structures.

The sensor substrate 110 may include a plurality of layers having different functions and stacked in a third direction (i.e., a Z-direction or a vertical direction). For example, the sensor substrate 110 may include a lower chip 110A, an upper chip 110B disposed on the lower chip 110A, and a sensor layer 110C disposed on the upper chip 110B. The lower chip 110A, the upper chip 110B, and the sensor layer 110C may extend across the active pixel sensor region APS and the periphery region PR. In other words, the lower chip 110A, the upper chip 110B, and the sensor layer 110C may extend across the active pixel sensor region APS, the optical black region PR1, the back-via-stack region PR2, and the contact pad region PR3. A logic circuit for driving the image sensor 1000 may be disposed in the lower chip 110A. For example, the timing controller 1010 and the row decoder 1020 shown in FIG. 1 may be disposed in the lower chip 110A, and a processor may also be disposed in the lower chip 110A. Circuits for outputting signals from the sensor layer 110C may be disposed in the upper chip 110B. For example, the output circuit 1030 shown in FIG. 1 may be disposed in the upper chip 110B. In addition, an amplification circuit for amplifying signals may be disposed in the upper chip 110B. A plurality of photodetection elements configured to convert incident light into electrical signals may be disposed in the sensor layer 110C. For example, the sensor layer 110C may include a plurality of photodiodes.

The active pixel sensor region APS may include a planarization layer 130 disposed on the upper surface of the sensor substrate 110, and a meta-optical element 150 disposed on the planarization layer 130. The planarization layer 130 and the meta-optical element 150 may be sequentially stacked on the sensor substrate 110 in the third direction. Accordingly, the meta-optical element 150 may face the sensor layer 110C of the sensor substrate 110 with the planarization layer 130 therebetween. Furthermore, in another embodiment, the active pixel sensor region APS may further include an etch stop layer 140 disposed between the planarization layer 130 and the meta-optical element 150. In addition, the active pixel sensor region APS may further include an anti-reflection layer 160 disposed on an upper surface of the meta-optical element 150. Accordingly, the meta-optical element 150 may be disposed between the etch stop layer 140 and the anti-reflection layer 160.

The sensor layer 110C of the sensor substrate 110 may include a plurality of pixels 111 and 112 that are two-dimensionally arranged in the active pixel sensor region APS in the first direction and the second direction. Each of the pixels 111 and 112 may include a photodiode. The meta-optical element 150 may direct incident light to each of the pixels 111 and 112 by splitting the incident light according to the wavelength of the incident light and/or condensing the incident light. To this end, the meta-optical element 150 may include a plurality of nanostructures NP arranged to form a predetermined meta-pattern, and a dielectric layer DL filled between the nanostructures NP. The nanostructures NP may include a material having a higher refractive index than a material of the dielectric layer DL. Although the nanostructures NP included in the meta-optical element 150 are illustrated as arranged in a single layer, this is only an example. In another example, the nanostructures NP may be may be arranged in a plurality of layers, such as two or three layers, in the Z-direction. In another embodiment in which the nanostructures NP are arranged in a plurality of layers, the etch stop layer 140 may be arranged not only below the lowermost layer of the nanostructures NP but also between the layers of the nanostructures NP.

Each of the planarization layer 130, the etch stop layer 140, the dielectric layer DL, and the anti-reflection layer 160 of the active pixel sensor region APS may extend as one body from the active pixel sensor region APS to the periphery region PR. For example, the planarization layer 130, the etch stop layer 140, the dielectric layer DL, and the anti-reflection layer 160 of the active pixel sensor region APS may extend from the active pixel sensor region APS across the optical black region PR1, the back-via-stack region PR2, and the contact pad region PR3.

The optical black region PR1 may include the light-shielding layer LS disposed on the upper surface of the sensor substrate 110 (for example, on an upper surface of the sensor layer 110C), the planarization layer 130 covering the light-shielding layer LS, and the dielectric layer DL disposed on the planarization layer 130. The planarization layer 130 and the dielectric layer DL of the optical black region PR1 each extend as one body in the first and second directions from the planarization layer 130 and the dielectric layer DL of the active pixel sensor region APS. That is, the planarization layer 130 and the dielectric layer DL may extend across the active pixel sensor region APS and the optical black region PR1. The dielectric layer DL may face the light-shielding layer LS and the sensor substrate 110 (for example, the sensor layer 110C of the sensor substrate 110), with the planarization layer 130 therebetween. The light-shielding layer LS may be disposed between the sensor layer 110C and the planarization layer 130, and the planarization layer 130 may be disposed between the light-shielding layer LS and the dielectric layer DL.

The optical black region PR1 may further include the etch stop layer 140 disposed between the planarization layer 130 and the dielectric layer DL, and the anti-reflection layer 160 disposed on an upper surface of the dielectric layer DL. The etch stop layer 140 and the anti-reflection layer 160 of the optical black region PR1 each extend as one body in the first and second directions from the etch stop layer 140 and the anti-reflection layer 160 of the active pixel sensor region APS. That is, the etch stop layer 140 and the anti-reflection layer 160 may extend across the active pixel sensor region APS and the optical black region PR1.

The light-shielding layer LS may be disposed across the entirety of the optical black region PR1. The anti-reflection layer 160, the dielectric layer DL, the etch stop layer 140, and the planarization layer 130 are optically transparent, and the light-shielding layer LS may prevent light passing through the anti-reflection layer 160, the dielectric layer DL, the etch stop layer 140, and the planarization layer 130 from reaching or entering the sensor layer 110C. In other words, the optical black region PR1 is substantially formed by the presence of the light-shielding layer LS.

The sensor layer 110C of the sensor substrate 110 may include a plurality of pixels 115 that are two-dimensionally arranged within the optical black region PR1 in the first and second directions. The light-shielding layer LS covers the pixels 115. Accordingly, light incident on the optical black region PR1 may not reach the pixels 115, and the pixels 115 in the optical black region PR1 may output dark signals.

Nanostructures NP may not be provided in the dielectric layer DL of the optical black region PR1. Crack stoppers having the same material and thickness as the nanostructures NP may be formed in the dielectric layer DL of the optical black region PR1.

The back-via-stack region PR2 may include one or more back via stacks 12 extending in the third direction within the sensor substrate 110. Each of the back via stacks 12 may extend in the third direction along the lower chip 110A, the upper chip 110B, and the sensor layer 110C to electrically connect circuits or elements of the lower chip 110A and the upper chip 110B to each other, circuits or elements of the upper chip 110B and the sensor layer 110C to each other, or circuits or elements of the lower chip 110A and the sensor layer 110C to each other.

The light-shielding layer LS of the optical black region PR1 may extend to a portion of the back-via-stack region PR2. Therefore, light incident obliquely on the back-via-stack region PR2 may be prevented from bypassing the light-shielding layer LS and reaching the pixels 115 of the optical black region PR1.

The back-via-stack region PR2 may also include the planarization layer 130, the etch stop layer 140 provided on the planarization layer 130, the dielectric layer DL provided on the etch stop layer 140, and the anti-reflection layer 160 provided on the dielectric layer DL. The planarization layer 130, the etch stop layer 140, the dielectric layer DL, and the anti-reflection layer 160 of the back-via-stack region PR2 each extend as one body from the active pixel sensor region APS in the first and second directions. In the back-via-stack region PR2, the planarization layer 130 may be in direct contact with a portion of the upper surface of the sensor substrate 110 and upper surfaces of the back via stacks 12. Furthermore, in the back-via-stack region PR2, nanostructures NP are not formed in the dielectric layer DL.

The contact pad region PR3 may include the contact pads 14 arranged in the upper surface of the sensor substrate 110. The contact pads 14 may be electrically connected to the input/output circuits provided in the image sensor 1000. For example, the contact pads 14 may be electrically connected to circuits or elements within the lower chip 110A, the upper chip 110B, or the sensor layer 110C. The contact pads 14 may be arranged on the upper surface of the sensor substrate 110, or may be embedded in the upper surface of the sensor substrate 110.

To form the contact pads 14, an edge portion of the upper surface of the sensor substrate 110 may be exposed by etching the planarization layer 130, the etch stop layer 140, the dielectric layer DL, and the anti-reflection layer 160 in the contact pad region PR3. The contact pads 14 may be arranged in the exposed edge portion of the upper surface of the sensor substrate 110. Accordingly, the planarization layer 130, the etch stop layer 140, the dielectric layer DL, and the anti-reflection layer 160 may extend only to a portion of the contact pad region PR3. However, embodiments are not limited thereto. For example, the planarization layer 130, the etch stop layer 140, the dielectric layer DL, and the anti-reflection layer 160 may be etched away from the entirety of the contact pad region PR3. In this case, the planarization layer 130, the etch stop layer 140, the dielectric layer DL, and the anti-reflection layer 160 may extend only to a portion of the back-via-stack region PR2.

The sensor layer 110C may not include photodiodes in the back-via-stack region PR2 and the contact pad region PR3. In other words, the back-via-stack region PR2 and the contact pad region PR3 do not include pixels configured to detect light. For ease of illustration, FIG. 3 illustrates that the thickness of the sensor substrate 110, for example, the thickness of the sensor layer 110C, is uniform in the back-via-stack region PR2, the contact pad region PR3, the active pixel sensor region APS, and the optical black region PR1. However, embodiments are not limited thereto. For example, because the sensor layer 110C does not include photodiodes in the back-via-stack region PR2 and the contact pad region PR3, the thickness of the sensor layer 110C may be smaller in the back-via-stack region PR2 and the contact pad region PR3 than in the active pixel sensor region APS and the optical black region PR1. In this case, a height difference may be present between the optical black region PR1 and the back-via-stack region PR2.

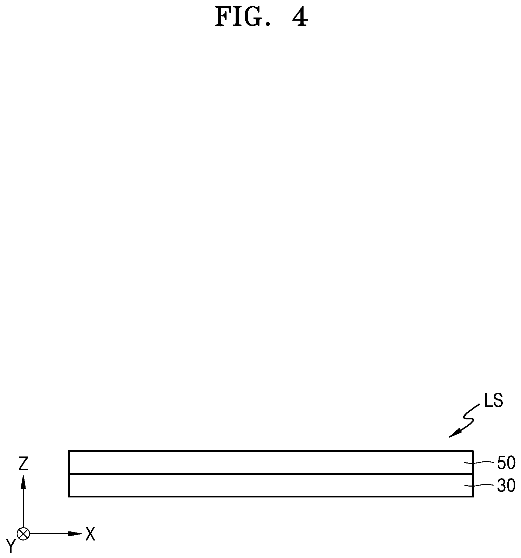

FIG. 4 is a cross-sectional view illustrating a structure of a light-shielding layer LS that may be provided in an image sensor, according to one or more embodiments.

The light-shielding layer LS may include a light-reflective layer 30 and a light-absorbing layer 50. The light-reflective layer 30 and the light-absorbing layer 50 may be sequentially disposed on the sensor substrate 110 shown in FIGS. 3 and 4. In one example, the light-reflective layer 30 may be disposed on the sensor layer 110C, and the light-absorbing layer 50 is disposed on top of the light-reflective layer 30. In another example, the light-absorbing layer 50 may be disposed on the sensor layer 110C, and the light-reflective layer 30 is disposed on top of the light-absorbing layer 50. The light-reflective layer 30 and the light-absorbing layer 50 may be in direct contact with each other, i.e., without any intervening layer therebetween. However, this is only an example, and in another embodiment, the light-shielding layer LS may further include an additional material layer disposed between the light-reflective layer 30 and the light-absorbing layer 50.

The light-reflective layer 30 may include a material that reflects light. The light-reflective layer 30 may include various metal materials such as chromium, copper, tungsten, nickel, or aluminum.

The light-absorbing layer 50 may include a material that absorbs light. The light-absorbing layer 50 may include, for example, amorphous carbon (a-C).

The light-absorbing layer 50 may have a thickness equal to or greater than about 10 nm and equal to or less than about 2 µm. The light-absorbing layer 50 may have a density equal to or greater than 2 g/cm³ and equal to or less than 3 g/cm³. The light-absorbing layer 50 may include an a-CₓSi₍₁₋ₓ₎ alloy or a-CₓSi₍₁₋ₓ₎N. The light-absorbing layer 50 may include amorphous carbon and a dopant with which the amorphous carbon is doped. Properties such as conductivity or refractive index of the light-absorbing layer 50 may be controlled by adjusting the dopant.

The amorphous carbon may be formed by various methods such as sputtering or plasma-enhanced chemical vapor deposition (PECVD), and may exhibit a wide range of physical properties depending on manufacturing conditions. Amorphous carbon may be chemically analyzed using a three-phase diagram consisting of sp²-C (graphite-like), sp³-C (diamond-like), and H (hydrogen). In the disclosure, the term "amorphous carbon" refers to a-C or hydrogenated amorphous carbon (a-C:H) that is distinguished from ta-C or diamond-like carbon having a very high sp³/sp² ratio.

As the sp³/sp² ratio of amorphous carbon increases, the density of amorphous carbon increases, for example, it exhibits a density of approximately greater than 3 g/cm³, and tends to be optically transparent. As the sp³/sp² ratio of amorphous carbon decreases, the proportion of sp¹ in the amorphous carbon may increase, and a higher sp¹ proportion significantly reduces thermal stability. Higher proportions of sp¹ and sp² increase the number of defects such as dangling bonds, which may be reduced through hydrogenation. However, hydrogenation may lead to processing defects due to dehydrogenation occurring at high temperatures, and optical absorbance decreases depending on the degree of hydrogenation. Therefore, to increase the optical absorbance of the light-absorbing layer 50 and ensure the thermal stability of the light-absorbing layer 50, the light-absorbing layer 50 may include amorphous carbon having medium to high density, for example, a density of about 2 g/cm³ to about 3 g/cm³, with a low sp1 proportion. To achieve optimal performance, the process of manufacturing amorphous carbon may include reducing hydrogenation, or thermal annealing or laser annealing of a thin film.

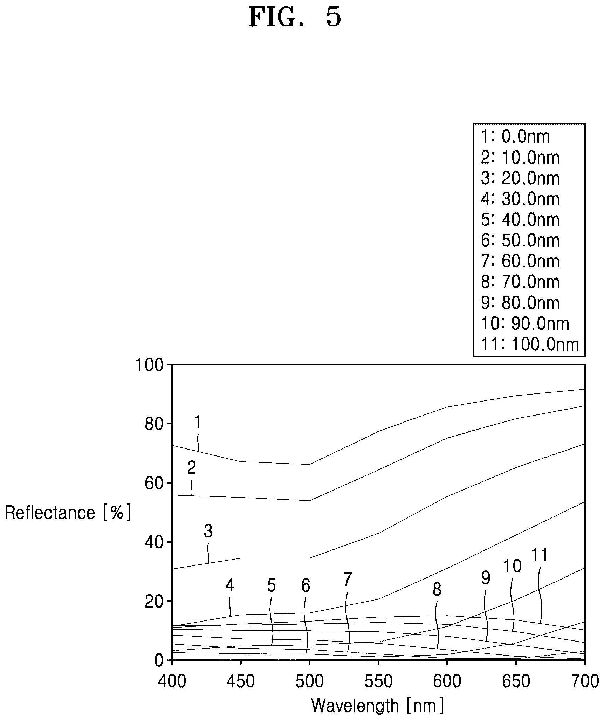

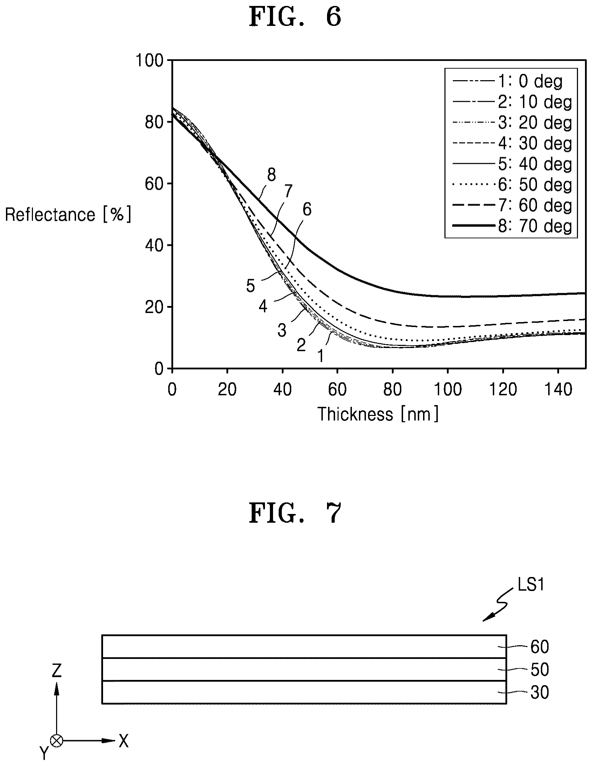

FIG. 5 is a graph illustrating wavelength-dependent reflection spectra by a light-shielding layer provided in an image sensor according to one or more embodiments, for various thicknesses of amorphous carbon. FIG. 6 is a graph illustrating the reflectance of the light-shielding layer provided in the image sensor according to one or more embodiments, with respect to the thickness of the amorphous carbon for various light incidence angles.

Referring to the graphs, the reflectance may be reduced to about 6% when the thickness of the amorphous carbon is about 65 nm. A thicker structure may be selected to increase absorption, that is, to reduce reflectance, in a long-wavelength range. Due to the high absorptivity of the amorphous carbon, even when the thickness of the amorphous carbon is increased, adverse effects occurring by multiple reflections are not significantly observed, and low reflectance is achieved across a wide spectral range.

The primary cause of reflection is the refractive index difference between an optically transparent layer and a light-absorbing layer. Some light may be reflected due to the refractive index difference between the light-absorbing layer 50 and the planarization layer 130 disposed on the light-shielding layer LS (refer to FIG. 3). Therefore, in some cases, an additional material layer may be disposed on the light-absorbing layer 50 to reduce such reflection.

FIG. 7 is a cross-sectional view illustrating a light-shielding layer LS1 that may be provided in an image sensor, according to one or more embodiments.

The light-shielding layer LS1 includes a light-reflective layer 30 and a light-absorbing layer 50. In addition, the light-shielding layer LS1 further includes an upper additional layer 60 disposed on the light-absorbing layer 50.

The upper additional layer 60 may include a material having a refractive index that is different from the refractive index of the planarization layer 130 (refer to FIG. 3). The refractive index of the upper additional layer 60 may between the refractive index of the planarization layer 130 and the refractive index of the light-absorbing layer 50. The thickness of the upper additional layer 60 and the thickness of the light-absorbing layer 50 may be set by considering the refractive index of the upper additional layer 60 and the refractive index of the light-absorbing layer 50 to reduce light reflected by multiple reflections.

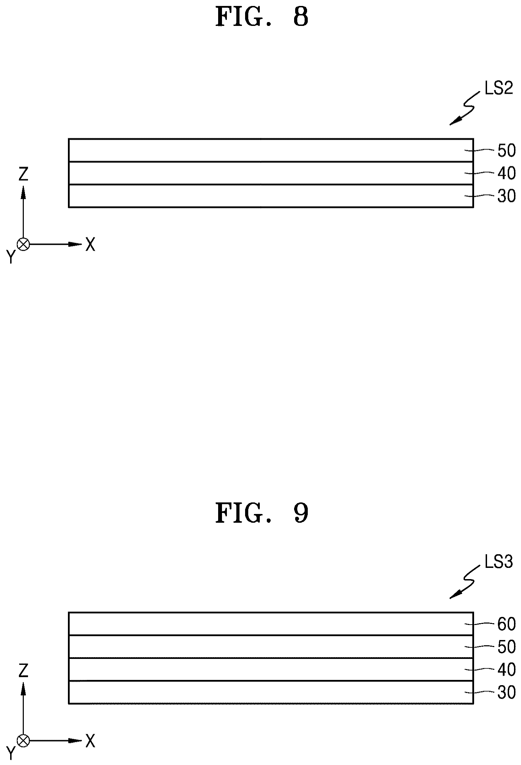

FIG. 8 is a cross-sectional view illustrating a light-shielding layer LS2 that may be provided in an image sensor, according to one or more embodiments.

The light-shielding layer LS2 includes a light-reflective layer 30 and a light-absorbing layer 50. In addition, the light-shielding layer LS2 further includes an intermediate additional layer 40 disposed between the light-reflective layer 30 and the light-absorbing layer 50.

The thicknesses of the intermediate additional layer 40 and the thickness of the light-absorbing layer 50 may be set by considering the refractive index of the intermediate additional layer 40 and the refractive index of the light-absorbing layer 50 to reduce light reflected by multiple reflections.

FIG. 9 is a cross-sectional view illustrating a light-shielding layer LS3 that may be provided in an image sensor, according to one or more embodiments.

The light-shielding layer LS3 includes a light-reflective layer 30 and a light-absorbing layer 50. In addition, the light-shielding layer LS3 further includes an intermediate additional layer 40 disposed between the light-reflective layer 30 and the light-absorbing layer 50, and an upper additional layer 60 disposed on the light-absorbing layer 50.

The thicknesses of the intermediate additional layer 40, the light-absorbing layer 50, and the upper additional layer 60 may be set by considering the refractive indexes of the intermediate additional layer 40, the light-absorbing layer 50, and the upper additional layer 60 to reduce light reflected by multiple reflections.

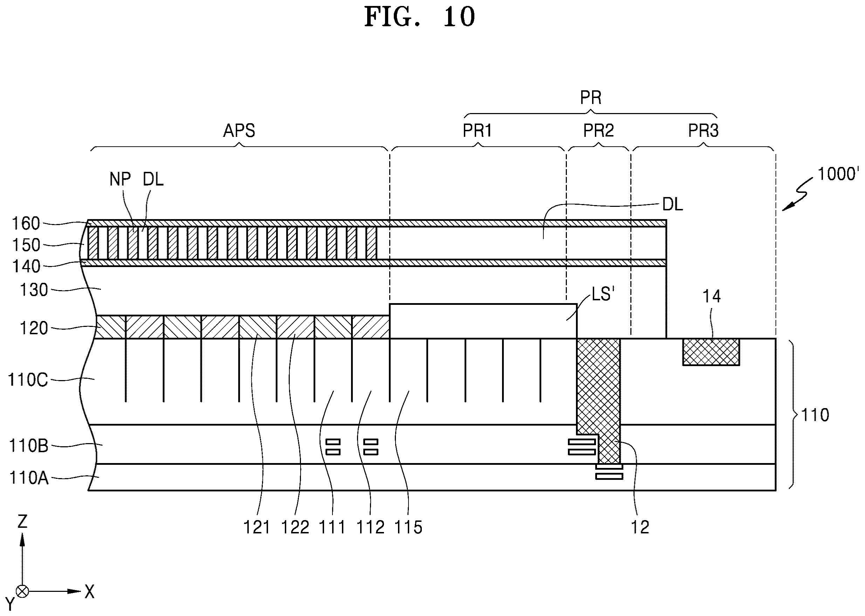

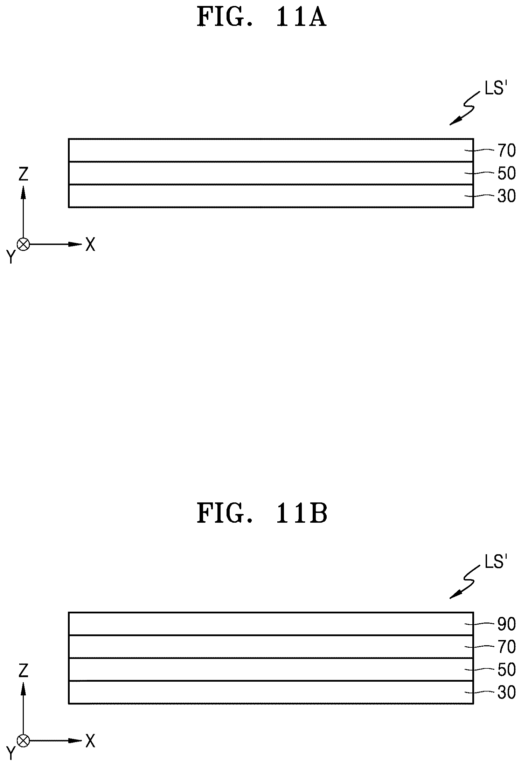

FIG. 10 is a cross-sectional view illustrating an image sensor 1000' according to one or more embodiments, and FIGS. 11A and 11B are cross-sectional views illustrating a light-shielding layer LS' that may be provided in the image sensor 1000' shown in FIG. 10.

The image sensor 1000' differs from the image sensor 1000 illustrated in FIG. 3 in that the image sensor 1000' further includes a color filter array layer 120 disposed on a sensor layer 110C in an active pixel sensor region APS.

The color filter array layer 120 may include a plurality of color filters 121 and 122 that are two-dimensionally arranged in first and second directions.

In an image sensor in which color separation is performed by a meta-optical element 150, the color filter array layer 120 may be omitted. However, the addition of the color filter array layer 120 may improve color purity.

The light-shielding layer LS' may be the same as the light-shielding layer LS described with reference to FIG. 3, or may differ slightly in some structures. In other words, any one of the light-shielding layers LS, LS1, LS2, and LS3 described above may be used as the light-shielding layer LS'. However, embodiments are not limited thereto. For example, a color filter material included in the color filter array layer 120 may also be included in the light-shielding layer LS'.

Referring to FIG. 11A, the light-shielding layer LS' may include a light-reflective layer 30, a light-absorbing layer 50, and a blue filter material layer 70. The blue filter material layer 70 may include the same material as a blue filter material included in the color filters 121 and 122 of the color filter array layer 120.

Although the blue color filter material layer 70 is illustrated as being directly disposed on the light-absorbing layer 50, the blue color filter material layer 70 is not limited thereto. For example, an interlayer material may additionally be disposed between the light-absorbing layer 50 and the blue color filter material layer 70, depending on requirements of manufacturing processes of the image sensor 1000'. The blue color filter material layer 70 may be disposed between a planarization layer 130 and the light-absorbing layer 50.

The blue color filter material layer 70 may transmit blue light and absorb green light and red light. Portions of green light and red light may not be absorbed by the blue color filter material layer 70, and may instead be absorbed by the light-absorbing layer 50. The blue color filter material layer 70 may prevent green or red light, which is not absorbed by the light-absorbing layer 50 and is reflected back, from being scattered and incident on pixels 111 and 112 in the active pixel sensor region APS. In general, blue light, which has a relatively short wavelength, is easily absorbed and thus has a relatively short propagation distance, whereas green and red light, which have relatively longer wavelengths, have longer propagation distances. Therefore, green or red light that is not absorbed and reflected by the light-shielding layer LS' is likely to reach the pixels 111 and 112 in the active pixel sensor region APS. The blue color filter material layer 70 absorbs green and red light from light entering the optical black region PR1, thereby preventing or reducing green or red light, not absorbed by the light-absorbing layer 50, from reaching the pixels 111 and 112 in the active pixel sensor region APS.

Referring to FIG. 11B, the light-shielding layer LS' may further include an upper additional layer 90 in addition to the light-reflective layer 30, the light-absorbing layer 50, the blue color filter material layer 70. The upper additional layer 90 may include a material having a refractive index that is different from the refractive index of the planarization layer 130. The upper additional layer 90 may reduce light reflection that may occur between the planarization layer 130 and the blue color filter material layer 70.

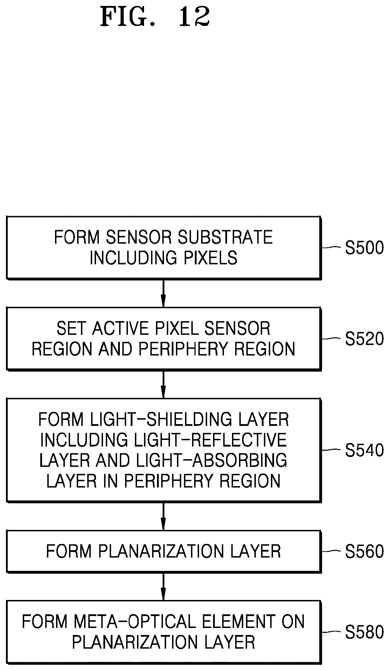

FIG. 12 is a flowchart schematically illustrating a method of manufacturing an image sensor, according to one or more embodiments.

Referring to FIG. 12, the method of manufacturing an image sensor may include forming a sensor substrate including a plurality of pixels configured to sense light (operation S500), and setting an active pixel sensor region and a periphery region (operation S520). The active pixel sensor region and the periphery region are the same as described with reference to FIGS. 2 and 3. The two operations S500 and S520 are not limited to the order shown in FIG. 12. For example, the active pixel sensor region and the periphery region may be set when the sensor substrate is formed.

A light-shielding layer including a light-reflective layer and a light-absorbing layer is formed in the periphery region (operation S540).

The light-shielding layer may be the same as any one of the light-shielding layers LS, LS1, LS2, LS3, and LS' each including the light-absorbing layer 50 containing amorphous carbon, or may be a modification or combination thereof.

In the operation S540 of forming the light-shielding layer, methods such as PECVD, magnetron sputtering (MS), rotary target magnetron sputtering (RMS), or sputtering may be used to form the light-absorbing layer. In addition, annealing may be additionally performed on the light-absorbing layer. In this case, thermal annealing or laser annealing may be performed on the light-absorbing layer. Conditions for the annealing may be set by considering optical absorbance and thermal stability.

The light-shielding layer may first be formed over the entire area of the sensor substrate and then patterned into a predetermined pattern. For example, after forming the light-shielding layer across both the active pixel sensor region and the periphery region, the light-shielding layer may be removed from the active pixel sensor region. In addition, the light-absorbing layer may become conductive depending on the method used to form the light-absorbing layer. In this case, patterning may be additionally performed to ensure insulating effects.

Next, a planarization layer extending from the active pixel sensor region to the periphery region and covering the light-shielding layer may be formed on the sensor substrate (operation S560).

In some cases, before forming the planarization layer, a color filter array layer may be formed on the sensor substrate in the active pixel sensor region.

A meta-optical element including a plurality of nanostructures may be formed on the planarization layer in a region corresponding to the active pixel sensor region (operation S580).

The image sensors 1000 and 1000' of the embodiments described above may form camera modules in combination with module lenses of various performance levels and may be used in various electronic devices.

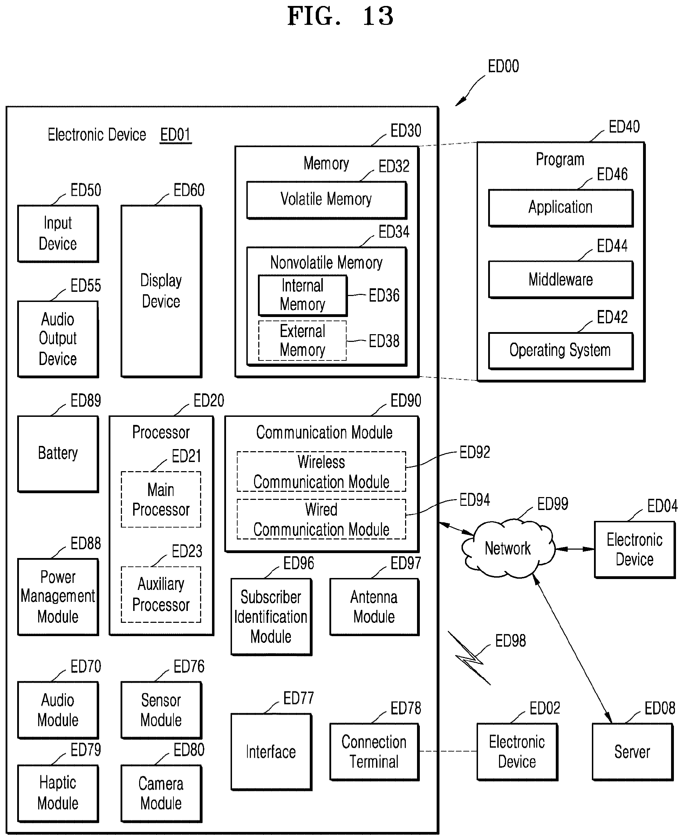

FIG. 13 is a block diagram schematically illustrating an electronic device ED01 including an image sensor, according to one or more embodiments. Referring to FIG. 13, in a network environment ED00, the electronic device ED01 may communicate with another electronic device ED02 through a first network ED98 (a near-field wireless communication network or the like) or may communicate with another electronic device ED04 and/or a server ED08 through a second network ED99 (a far-field wireless communication network or the like). The electronic device ED01 may communicate with the electronic device ED04 through the server ED08. The electronic device ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. Some (the display device ED60 or the like) of the components may be omitted from the electronic device ED01, or other components may be added to the electronic device ED01. Some of the components may be implemented in one integrated circuit. For example, the sensor module ED76 (a fingerprint sensor, an iris sensor, an illuminance sensor, or the like) may be embedded in the display device ED76 (a display or the like).

The processor ED20 may execute software (a program ED40 or the like) to control one or more other components (hardware or software components, or the like) of the electronic device ED01 connected to the processor ED20, and may perform a variety of data processing or operations. As a portion of the data processing or operations, the processor ED20 may load instructions and/or data received from other components (the sensor module ED76, the communication module ED90, or the like) into a volatile memory ED32, process the instructions and/or data stored in the volatile memory ED32, and store result data in a nonvolatile memory ED34. The processor ED20 may include a main processor ED21 (a central processing unit, an application processor, or the like) and an auxiliary processor ED23 (a graphics processing unit, an image signal processor, a sensor hub processor, a communication processor, or the like), which is operated independently or together with the main processor ED21. The auxiliary processor ED23 may consume less power than the main processor ED21 and may perform specialized functions.

The auxiliary processor ED23 may control functions and/or states related to some (the display device ED60, the sensor module ED76, the communication module ED90, or the like) of the components of the electronic device ED01 on behalf of the main processor ED21 while the main processor ED21 is in an inactive (e.g., sleep) state or together with the main processor ED21 while the main processor ED21 is in an active (e.g., application execution) state. The auxiliary processor ED23 (an image signal processor, a communication processor, or the like) may be implemented as a portion of other functionally relevant components (the camera module ED80, the communication module ED90, or the like).

The memory ED30 may store a variety of data required by the components (the processor ED20, the sensor module ED76, or the like) of the electronic device ED01. The data may include, for example, software (the program ED40 or the like) and input data and/or output data for commands related thereto. The memory ED30 may include the volatile memory ED32 and/or the nonvolatile memory ED34.

The program ED40 may be stored as software in the memory ED30, and may include an operating system ED42, middleware ED44, and/or an application ED46.

The input device ED50 may receive commands and/or data to be used for the components (the processor ED20 or the like) of the electronic device ED01 from the outside (a user or the like) of the electronic device ED01. The input device ED50 may include a microphone, a mouse, a keyboard, and/or a digital pen (a stylus pen or the like).

The audio output device ED55 may output an audio signal to the outside of the electronic device ED01. The audio output device ED55 may include a speaker and/or a receiver. The speaker may be used for general purposes such as multimedia playback or record playback, and the receiver may be used to receive incoming calls. The receiver may be provided as a portion of the speaker or may be implemented as a separate device.

The display device ED60 may visually provide information to the outside of the electronic device ED01. The display device ED60 may include a display, a hologram device, or a projector, and a control circuit for controlling devices. The display device ED60 may include touch circuitry set to sense a touch, and/or sensor circuitry (a pressure sensor or the like) configured to measure the intensity of force generated by the touch.

The audio module ED70 may convert sound into an electrical signal, and vice versa. The audio module ED70 may obtain sound through the input device ED50, or may output sound through the audio output device ED55 and/or speakers and/or headphones of another electronic device (the electronic device ED02 or the like) directly or wirelessly connected to the electronic device ED01.

The sensor module ED76 may detect an operating state (power, temperature, or the like) of the electronic device ED01 or an external environmental state (user status or the like), and may generate an electrical signal and/or a data value corresponding to the detected state. The sensor module ED76 may include a gesture sensor, a gyro sensor, a barometric sensor, a magnetic sensor, an acceleration sensor, a grip sensor, a proximity sensor, a color sensor, an infrared (IR) sensor, a biological sensor, a temperature sensor, a humidity sensor, and/or an illuminance sensor.

The interface ED77 may support one or more designated protocols, which may be used to directly or wirelessly connect the electronic device ED01 with other electronic devices (the electronic device ED02 or the like). The interface ED77 may include a high definition multimedia interface (HDMI), a universal serial bus (USB) interface, a secure digital (SD) card interface, and/or an audio interface.

A connection terminal ED78 may include a connector through which the electronic device ED01 may be physically connected to other electronic devices (the electronic device ED02 or the like). The connection terminal ED78 may include an HDMI connector, a USB connector, an SD card connector, and/or an audio connector (a headphones connector or the like).

The haptic module ED79 may convert an electrical signal into a mechanical stimulus (vibration, movement, or the like) or an electrical stimulus that a user may perceive through tactile sensation or kinesthesia. The haptic module ED79 may include a motor, a piezoelectric element, and/or an electric stimulation device.

The camera module ED80 may capture a still image and a moving image. The camera module ED80 may include a lens assembly having one or more lenses, the image sensor 1000 shown in FIG. 1, an image signal processor, and/or a flash. The lens assembly included in the camera module ED80 may collect light coming from an object to be imaged.

The power management module ED88 may manage power supplied to the electronic device ED01. The power management module ED88 may be implemented as a portion of a power management integrated circuit (PMIC).

The battery ED89 may supply power to components of the electronic device ED01. The battery ED89 may include a non-rechargeable primary battery, a rechargeable secondary battery, and/or a fuel cell.

The communication module ED90 may support establishment of a direct (wired) communication channel and/or a wireless communication channel between the electronic device ED01 and other electronic devices (the electronic device ED02, the electronic device ED04, the server ED08, or the like), and communication through the established communication channel. The communication module ED90 operates independently of the processor ED20 (an application processor or the like) and may include one or more communication processors supporting direct communication and/or wireless communication. The communication module ED90 may include a wireless communication module ED92 (a cellular communication module, a short-range wireless communication module, a global navigation satellite system (GNSS), or the like) and/or a wired communication module ED94 (a local area network (LAN) communication module, a power line communication module, or the like). A corresponding communication module from among these communication modules may communicate with other electronic devices through the first network ED98 (a local area network such as Bluetooth, WiFi Direct, or IR data association (IrDA)) or the second network ED99 (a telecommunication network such as a cellular network, the Internet, or computer networks (LAN, WAN, or the like)). These various types of communication modules may be integrated into a single component (a single chip or the like) or may be implemented as a plurality of separate components (multiple chips). The wireless communication module ED92 may identify and authenticate the electronic device ED01 within a communication network such as the first network ED98 and/or the second network ED99 by using subscriber information (an international mobile subscriber identifier (IMSI) or the like) stored in the subscriber identification module ED96.

The antenna module ED97 may transmit and/or receive signals and/or power to and/or from the outside (other electronic devices or the like). An antenna may include a radiator made of a conductive pattern formed on a substrate (a PCB or the like). The antenna module ED97 may include one or more such antennas. When a plurality of antennas are included in the antenna module ED97, the communication module ED90 may select an antenna suitable for a communication method used in a communication network, such as the first network ED98 and/or the second network ED99, among the plurality of antennas. Signals and/or power may be transmitted or received between the communication module ED90 and other electronic devices through the selected antenna. Other components (a radio-frequency integrated circuit (RFIC) or the like) besides the antenna may be included as part of the antenna module ED97.

Some of the components may be connected to each other and exchange signals (commands, data or the like) through a communication method between peripheral devices (a bus, general purpose input and output (GPIO), a serial peripheral interface (SPI), a mobile industry processor interface (MIPI), or the like).

Commands or data may be transmitted or received between the electronic device ED01 and an external apparatus such as the electronic device ED04 through the server ED08 connected to the second network ED99. The other electronic devices ED02 and ED04 may be the same as or different from the electronic device ED01. All or some of the operations of the electronic device ED01 may be executed by one or more of the other electronic devices ED02, ED04, and ED08. For example, when the electronic device ED01 needs to perform certain functions or services, the electronic device ED01 may request one or more other electronic devices to perform some or all of the functions or services instead of directly executing the functions or services. One or more other electronic devices that have received the request may execute an additional function or service related to the request, and may transfer results of the execution to the electronic device ED01. To this end, cloud computing, distributed computing, and/or client-server computing techniques may be used.

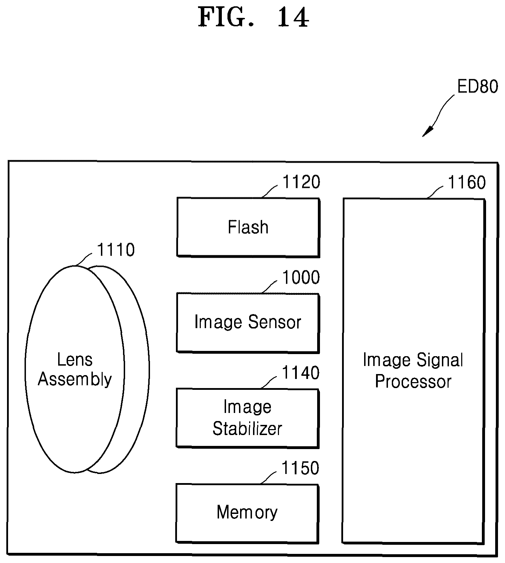

FIG. 14 is a block diagram illustrating the camera module ED80 of the electronic device ED01 shown in FIG. 13. Referring to FIG. 14, the camera module ED80 may include a lens assembly 1110, a flash 1120, an image sensor 1000, an image stabilizer 1140, a memory 1150 (a buffer memory or the like), and/or an image signal processor 1160. The lens assembly 1110 may collect light emitted from an object to be photographed. The camera module ED80 may include a plurality of lens assemblies 1110, and in this case, the camera module ED80 may include a dual camera, a 360-degree camera, or a spherical camera. Some of the lens assemblies 1110 may have the same lens attributes (a viewing angle, a focal length, auto focus, F Number, optical zoom, and the like), or different lens attributes. The lens assembly 1110 may include a wide angle lens or a telescopic lens.

The flash 1120 may emit light to reinforce light emitted or reflected from an object. The flash 1120 may emit visible light or IR light. The flash 1120 may include one or a plurality of light-emitting diodes (a red-green-blue (RGB) LED, a white LED, an infrared LED, an ultraviolet LED, and the like), and/or a xenon lamp. The image sensor 1000 may be any one of the image sensors 1000 and 1000' described above, and convert light emitted or reflected from the object and transmitted through the lens assembly 1110 into electrical signals, thereby obtaining an image corresponding to the object.

The image stabilizer 1140 may move, in response to a movement of the camera module ED80 or the electronic device ED01 including the camera module ED80, one or a plurality of lenses included in the lens assembly 1110 or the image sensor 1000 in a particular direction, or may control the movement characteristics (read-out timing or the like) of the image sensor 1000, thereby compensating for a negative effect caused by the movement of the camera module ED80 or the electronic device ED01. The image stabilizer 1140 may detect a movement of the camera module ED80 or the electronic device ED01 by using a gyro sensor or an acceleration sensor arranged inside or outside the camera module ED80. The image stabilizer 1140 may be implemented in an optical form.

The memory 1150 may store a part or entire data of an image obtained through the image sensor 1000 for a subsequent image processing operation. For example, when a plurality of images are obtained at high speed, only low resolution images are displayed while the obtained original data (Bayer-Patterned data, high resolution data, and the like) is stored in the memory 1150. Then, the memory 1150 may be used to transmit the original data of a selected (user selection or the like) image to the image signal processor 1160. The memory 1150 may be incorporated into the memory ED30 of the electronic device ED01, or configured to be an independently operated separate memory.

The image signal processor 1160 may obtain an image by using electrical signals output from the image sensor 1000. For example, the image signal processor 1160 may directly perform a part of image processing in association with the image sensor 1000. In addition, the image signal processor 1160 may request image data in a specific format from the image sensor 1000 according to a required format of image data.

In addition, the image signal processor 1160 may perform additional image processing on the image obtained through the image sensor 1000 or the image data stored in the memory 1150. The image processing may include depth map generation, 3D modeling, panorama generation, feature point extraction, image synthesis, and/or image compensation (noise reduction, resolution adjustment, brightness adjustment, blurring, sharpening, softening, and the like). The image signal processor 1160 may perform control (exposure time control, read-out timing control, or the like) on components (the image sensor 1000 or the like) included in the camera module ED80.

The image processed by the image signal processor 1160 may be stored again in the memory 1150 for additional processing or provided to external devices (the memory ED30, the display device ED60, the electronic device ED02, the electronic device ED04, the server ED08, and the like) provided outside the camera module ED80. The image signal processor 1160 may be incorporated into the processor ED20, or configured to be a separate processor operated independently of the processor ED20. When the image signal processor 1160 is implemented as a processor separate from the processor ED20, the image processed by the image signal processor 1160 may undergo additional image processing by the processor ED20 and then displayed on the display device ED60.

In addition, the image signal processor 1160 may independently receive two output signals from adjacent light sensing cells provided in each pixel or sub-pixel of the image sensor 1000 and generate an automatic focus signal from a difference between the two output signals. The image signal processor 1160 may control the lens assembly 1110 to accurately apply the focus of the lens assembly 1110 on the surface of the image sensor 1000 based on the automatic focus signal.

The electronic device ED01 may further include one or more additional camera modules ED80 having different attributes or functions. The additional camera modules ED80 may each include components similar to those of the camera module ED80 shown in FIG. 14, and the image sensors provided in the additional camera modules ED80 may be implemented as charged coupled device (CCD) sensors and/or complementary metal oxide semiconductor (CMOS) sensors and may include one or more sensors selected from sensors having different properties such as RGB sensors, black and white (BW) sensors, IR sensors, and ultraviolet (UV) sensors. In this case, one of the camera modules ED80 may be a wide angle camera, and another may be a telescopic camera. Similarly, one of the camera modules ED80 may be a front side camera, and another may be a read side camera.

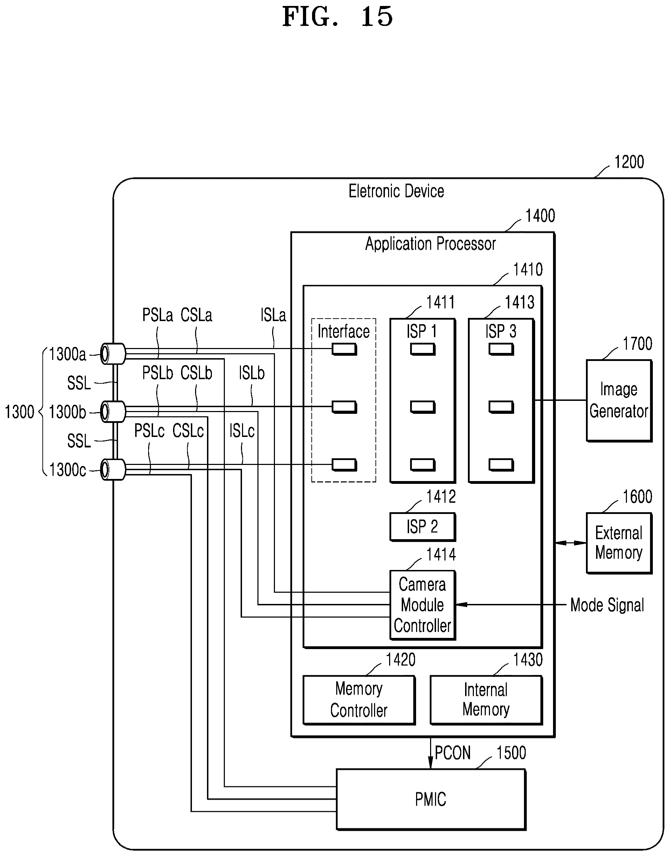

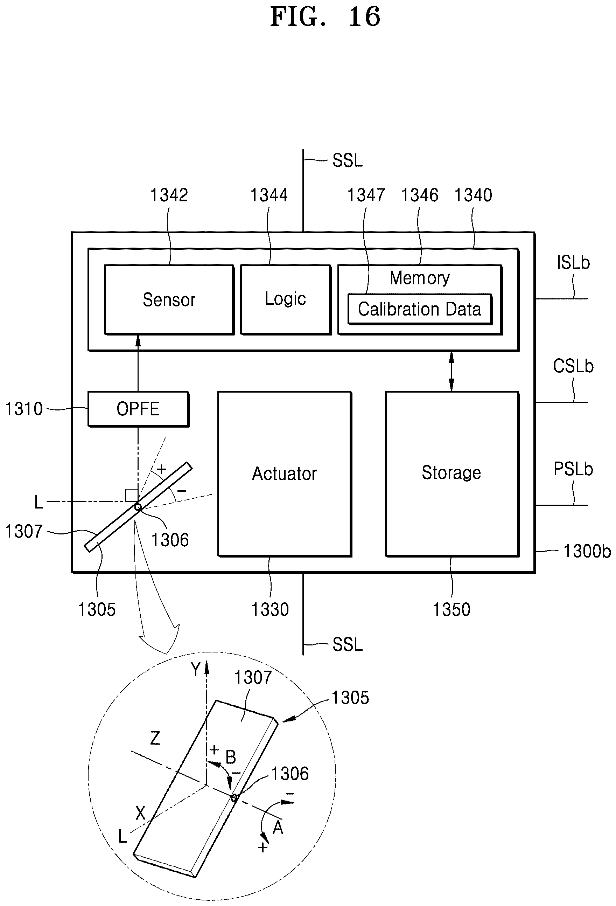

FIG. 15 is a block diagram illustrating an electronic device 1200 including multiple camera modules, and FIG. 16 is a block diagram illustrating a camera module 1300b of the electronic device 1200 shown in FIG. 15.

Referring to FIG. 15, the electronic device 1200 may include a camera module group 1300, an application processor 1400, PMIC 1500, an external memory 1600, and an image generator 1700.

The camera module group 1300 may include a plurality of camera modules 1300a, 1300b, and 1300c. Although three camera modules 1300a, 1300b, and 1300c are illustrated in FIG. 15, embodiments are not limited thereto. In some embodiments, the camera module group 1300 may be modified to include only two camera modules. In some embodiments, the camera module group 1300 may be modified to include n camera modules (n refers to a natural number greater than or equal to 4).

The configuration of the camera module 1300b will be described below with reference to FIG. 16. The following description of the camera module 1300b may also be applied to the other camera modules 1300a and 1300c.

Referring to FIG. 16, the camera module 1300b may include a prism 1305, an optical path folding element (OPFE) 1310, an actuator 1330, an image sensing device 1340, and a storage 1350.

The prism 1305 may include a reflective surface 1307 of a light reflecting material and may change the path of light L incident from the outside.

In some embodiments, the prism 1305 may change the path of light L incident in a first direction (X-direction) to a second direction (Y-direction) perpendicular to the first direction (X-direction). The prism 1305 may rotate the reflective surface 1307 of the light reflecting material in a direction A around a center shaft 1306 or rotate the center shaft 1306 in a direction B to change the path of light L incident in the first direction (X-direction) to the second direction (Y-direction) perpendicular to the first direction (X-direction). In this case, the OPFE 1310 may move in a third direction (Z-direction) that is perpendicular to both of the first direction (X-direction) and the second direction (Y-direction).

In some embodiments, as illustrated in FIG. 16, an A-direction maximum rotation angle of the prism 1305 may be less than or equal to 15 degrees in a positive (+) direction A and greater than 15 degrees in a negative (-) direction A. However, embodiments are not limited thereto.

In some embodiments, the prism 1305 may move by an angle of about 20 degrees or in a range from about 10 degrees to about 20 degrees or from about 15 degrees to about 20 degrees in a positive (+) or negative (-) direction B. In this case, an angle by which the prism 1305 moves in the positive (+) direction B may be the same as or similar, within a difference of about 1 degree, to an angle by which the prism 1305 moves in the negative (-) direction B.

In some embodiments, the prism 1305 may move the reflective surface 1307 of the light reflecting material in the third direction (Z-direction) parallel with an extension direction of the center shaft 1306.

The OPFE 1310 may include, for example, m optical lenses where m refers to a natural number. The m optical lenses may move in the second direction (Y-direction) and change an optical zoom ratio of the camera module 1300b. For example, when the default optical zoom ratio of the camera module 1300b is Z, the optical zoom ratio of the camera module 1300b may be changed to 3Z, 5Z, 10Z or greater by moving the m optical lenses included in the OPFE 1310.

The actuator 1330 may move the OPFE 1310 or the m optical lenses (hereinafter referred to as the optical lens) to a certain position. For example, the actuator 1330 may adjust the position of the optical lens such that an image sensor 1342 may be positioned at a focal length of the optical lens for accurate sensing.

The image sensing device 1340 may include the image sensor 1342, control logic 1344, and memory 1346. The image sensor 1342 may sense an image of a target by using light L provided through the optical lens. The control logic 1344 may control the overall operation of the camera module 1300b. For example, the control logic 1344 may control the operation of the camera module 1300b according to control signals provided through a control signal line CSLb.

The memory 1346 may store information, such as calibration data 1347, necessary for operations of the camera module 1300b. The calibration data 1347 may include information that is necessary for the camera module 1300b to generate image data using light L incident from the outside. For example, the calibration data 1347 may include information about the degree of rotation, information about a focal length, information about an optical axis, or the like. When the camera module 1300b is implemented as a multi-state camera that has a focal length varying with the position of the optical lens, the calibration data 1347 may include a focal length value for each position (or state) of the optical lens and information about auto focusing.

The storage 1350 may store image data sensed by the image sensor 1342. The storage 1350 may be provided outside the image sensing device 1340 and may form a stack with a sensor chip of the image sensing device 1340. In some embodiments, the storage 1350 may include electrically erasable programmable read-only memory (EEPROM). However, embodiments are not limited thereto.

Referring to FIGS. 15 and 16, in some embodiments, the camera modules 1300a, 1300b, and 1300c may respectively include actuators 1330. In this case, the camera modules 1300a, 1300b, and 1300c may include the same or different pieces of calibration data 1347 according to operations of the actuators 1330 of the camera modules 1300a, 1300b, and 1300c.

In some embodiments, one (for example, the camera module 1300b) of the camera modules 1300a, 1300b, and 1300c may be of a folded-lens type including the prism 1305 and the OPFE 1310 while the other camera modules (for example, the camera modules 1300a and 1300b) may be of a vertical type that does not include the prism 1305 and the OPFE 1310. However, embodiments are not limited thereto.

In some embodiments, one (for example, the camera module 1300c) of the camera modules 1300a, 1300b, and 1300c may include a depth camera of a vertical type that is capable of extracting depth information using infrared (IR) rays.

In some embodiments, at least two camera modules (for example, the camera modules 1300a and 1300b) among the camera modules 1300a, 1300b, and 1300c may have different fields of view. In this case, for example, the at least two camera modules (for example, the camera modules 1300a and 1300b) among the camera modules 1300a, 1300b, and 1300c may respectively have different optical lenses. However, embodiments are not limited thereto.

In some embodiments, the camera modules 1300a, 1300b, and 1300c may have fields of view that are different from each other. In this case, the camera modules 1300a, 1300b, and 1300c may have different optical lenses. However, embodiments are not limited thereto.

In some embodiments, the camera modules 1300a, 1300b, and 1300c may be physically separated from each other. That is, instead of dividing the sensing area of one image sensor 1342 for the camera modules 1300a, 1300b, and 1300c, the camera modules 1300a, 1300b, and 1300c may respectively include independent image sensors 1342.

Referring back to FIG. 15, the application processor 1400 may include an image processing unit 1410, a memory controller 1420, and an internal memory 1430. The application processor 1400 may be implemented separately from the camera modules 1300a, 1300b, and 1300c. For example, the application processor 1400 and the camera modules 1300a, 1300b, and 1300c may be implemented in different semiconductor chips separate from each other.

The image processing unit 1410 may include a plurality of image processors 1411, 1412, and 1413, and a camera module controller 1414.

Pieces of image data respectively generated by the camera modules 1300a, 1300b, and 1300c may be provided to the image processing unit 1410 respectively through image signal lines ISLa, ISLb, and ISLc separated from each other. Such image data transmission may be performed using, for example, camera serial interface (CSI) that is based on MIPI. However, embodiments are not limited thereto.

The image data transmitted to the image processing unit 1410 may be stored in the external memory 1600 before being transferred to the image processors 1411 and 1412. The image data stored in the external memory 1600 may be provided to the image processor 1411 and/or the image processor 1412. The image processor 1411 may correct the received image data to generate a moving image. The image processor 1412 may correct the received image data to generate a still image. For example, the image processors 1411 and 1412 may perform preprocessing operations such as color correction and gamma correction on the image data.

The image processor 1411 may include sub-processors. When the number of sub-processors is equal to the number of camera modules 1300a, 1300b, and 1300c, each of the sub-processors may process image data provided by one camera module. When the number of sub-processors is less than the number of camera modules 1300a, 1300b, 1300c, at least one of the sub-processors may process image data provided by multiple camera modules through a time-sharing process. The image data processed by the image processor 1411 and/or image processor 1412 may be stored in the external memory 1600 before being transferred to the image processor 1413. The image data stored in the external memory 1600 may be transferred to the image processor 1413. The image processor 1413 may perform post-processing operations such as noise correction and sharpening correction on the image data.

The image data processed by the image processor 1413 may be provided to the image generator 1700. The image generator 1700 may generate a final image according to image generation information or a mode signal by using the image data received from the image processor 1413.

For example, according to the image generation information or the mode signal, the image generator 1700 may generate an output image by merging at least portions of pieces of image data that are respectively generated by the camera modules 1300a, 1300b, and 1300c having different fields of view. In addition, according to the image generation information or the mode signal, the image generator 1700 may generate an output image by selecting one of pieces of image data that are respectively generated by the camera modules 1300a, 1300b, and 1300c having different fields of view.

In some embodiments, the image generation information may include a zoom signal or a zoom factor. In some embodiments, the mode signal may be based on a mode selected by a user.

When the image generation information includes a zoom signal (zoom factor) and the camera modules 1300a, 1300b, and 1300c have different fields of view, the image generator 1700 may perform different operations according to the type of the zoom signal. For example, when the zoom signal is a first signal, the image generator 1700 may merge image data output from the camera module 1300a with image data output from the camera module 1300c, and may then generate an output image by using the merged image data (merged image signal) and image data that is output from the camera module 1300b and not merged with other image data. When the zoom signal is a second signal different from the first signal, the image generator 1700 may generate an output image by selecting one of the pieces of image data respectively output from the camera modules 1300a, 1300b, and 1300c, instead of merging the pieces of image data with each other. However, embodiments are not limited thereto, and a method of processing image data may be changed whenever necessary.

The camera module controller 1414 may provide a control signal to each of the camera modules 1300a, 1300b, and 1300c. Control signals generated by the camera module controller 1414 may be provided to the camera modules 1300a, 1300b, and 1300c through separate control signal lines CSLa, CSLb, and CSLc.

In some embodiments, a control signal provided from the camera module controller 1414 to each of the camera modules 1300a, 1300b, and 1300c may include mode information relating to a mode signal. The camera modules 1300a, 1300b, and 1300c may operate in a first operation mode or a second operation mode in relation with a sensing speed based on the mode information.

In the first operation mode, the camera modules 1300a, 1300b, and 1300c may generate an image signal at a first speed (for example, at a first frame rate), encode the image signal at a second speed greater than the first speed (for example, at a second frame rate greater than the first frame rate), and transmit the encoded image signal to the application processor 1400. In this case, the second speed may be less than or equal to 30 times the first speed.

The application processor 1400 may store the received image signal, that is, the encoded image signal, in the internal memory 1430 or the external memory 1600 provided outside the application processor 1400. Thereafter, the application processor 1400 may read the encoded image signal from the internal memory 1430 or the external memory 1600, decode the encoded image signal, and display image data generated based on the decoded image signal. For example, the image processors 1411 and 1412 of the image processing unit 1410 may decode the encoded image signal and may also perform image processing on the decoded image signal.

In the second operation mode, the camera modules 1300a, 1300b, and 1300c may generate an image signal at a third speed less than the first speed (for example, at a third frame rate less than the first frame rate) and may transmit the image signal to the application processor 1400. The image signal provided to the application processor 1400 may be a non-encoded image signal. The application processor 1400 may perform image processing on the image signal or store the image signal in the internal memory 1430 or the external memory 1600.

The PMIC 1500 may provide power, for example, power supply voltage, to each of the camera modules 1300a, 1300b, and 1300c. For example, under control by the application processor 1400, the PMIC 1500 may provide a first piece of power to the camera module 1300a through a power signal line PSLa, a second piece of power to the camera module 1300b through a power signal line PSLb, and a third piece of power to the camera module 1300c through a power signal line PSLc.

The PMIC 1500 may generate power corresponding to each of the camera modules 1300a, 1300b, and 1300c and adjust the level of power, in response to a power control signal PCON received from the application processor 1400. The power control signal PCON may include a power adjustment signal for each operation mode of the camera modules 1300a, 1300b, and 1300c. For example, the operation mode may include a low-power mode. In this case, the power control signal PCON may include information about a camera module to be operated in the low-power mode and information on a set power level. The same level or different levels of power may be provided to the camera modules 1300a, 1300b, and 1300c. In addition, the level of power may be dynamically varied.

The embodiments described above may be summarized as follows.
(1) According to one or more embodiments, an image sensor includes an active pixel sensor region outputting a pixel signal for image generation, and a periphery region surrounding the active pixel sensor region. The active pixel sensor region and the periphery region include a sensor substrate including a plurality of pixels arranged across the active pixel sensor region and the periphery region. The active pixel sensor region includes a meta-optical element facing the sensor substrate at a distance from the sensor substrate and including a plurality of nanostructures. The periphery region includes a light-shielding layer disposed on the sensor substrate and surrounding the active pixel sensor region. The light-shielding layer includes a light-reflective layer including a light-reflecting material and a light-absorbing layer including amorphous carbon.
(2) The light-absorbing layer may may have a thickness of about 10 nm to about 2 µm.
(3) The light-absorbing layer may may have a density of about 2 g/cm³ to about 3 g/cm³.
(4) The light-absorbing layer may include an a-CₓSi₍₁₋ₓ₎ alloy or a-CₓSi₍₁₋ₓ₎N.
(5) The light-absorbing layer may further include a dopant with which the amorphous carbon is doped.
(6) The light-reflective layer may include a metal.
(7) The light-reflective layer and the light-absorbing layer of the light-shielding layer may be sequentially disposed on the sensor substrate.
(8) The light-reflective layer and the light-absorbing layer may be in direct contact with each other.
(9) The light-shielding layer may further include an intermediate additional layer disposed between the light-reflective layer and the light-absorbing layer and having a refractive index that is different from a refractive index of the light-absorbing layer.
(10) The active pixel sensor region may further include a color filter array layer disposed between the sensor substrate and the meta-optical element.
(11) The light-shielding layer may further include a blue filter material layer disposed on the light-absorbing layer.
(12) The image sensor may further include a planarization layer extending from the active pixel sensor region to the periphery region and covering the color filter array layer and the light-shielding layer.
(13)The light-shielding layer may further include an upper additional layer disposed on the blue filter material layer and having a refractive index that is different from a refractive index of the planarization layer.
(14) According to one or more embodiments, a method of manufacturing an image sensor includes forming a sensor substrate including a plurality of pixels configured to sense light, setting regions of the sensor substrate as an active pixel sensor region and a periphery region surrounding the active pixel sensor region, forming a light-shielding layer including a light-reflective layer and a light-absorbing layer on the sensor substrate in a region corresponding to the periphery region, forming a planarization layer on the sensor substrate, the planarization layer extending from the active pixel sensor region to the periphery region and covering the light-shielding layer, and forming a meta-optical element including a plurality of nanostructures on the planarization layer in a region corresponding to the active pixel sensor region, wherein the forming of the light-shielding layer includes forming the light-reflective layer including a light-reflecting material, and forming the light-absorbing layer including amorphous carbon on the light-reflective layer.
(15) The forming of the light-shielding layer may include forming the light-shielding layer on the sensor substrate across the active pixel sensor region and the periphery region, and removing the light-shielding layer from the active pixel sensor region.
(16) The forming of the light-shielding layer may further include annealing the light-absorbing layer after forming the light-absorbing layer.
(17) The light-absorbing layer may may have a thickness of about 10 nm to about 2 µm, and the light-absorbing layer may may have a density of about 2 g/cm³ to about 3 g/cm³.
(18) The light-absorbing layer may include an a-CₓSi₍₁₋ₓ₎ alloy or a-CₓSi₍₁₋ₓ₎N.
(19) The forming of the light-absorbing layer may be performed by PECVD, MS, RMS, or sputtering.
(20) According to one or more embodiments, an electronic device includes a lens assembly forming an optical image of an object, and an image sensor converting the optical image formed by the lens assembly into an electrical signal. The image sensor includes an active pixel sensor region outputting a pixel signal for image generation, and a periphery region surrounding the active pixel sensor region. The active pixel sensor region and the periphery region include a sensor substrate including a plurality of pixels arranged across the active pixel sensor region and the periphery region. The active pixel sensor region includes a meta-optical element facing the sensor substrate at a distance from the sensor substrate and including a plurality of nanostructures. The periphery region includes a light-shielding layer disposed on the sensor substrate and surrounding the active pixel sensor region. The light-shielding layer includes a light-reflective layer including a light-reflecting material and a light-absorbing layer including amorphous carbon.

In each of the image sensors described above, the light-shielding layer formed in the periphery region surrounding the active pixel sensor region of the image sensor includes a light-reflective material and a light-absorbing material, and thus, the quality of images formed in the active pixel sensor region may be improved.

The light-shielding layer may also be used even when color filters are not provided in the active pixel sensor region.

The image sensor manufacturing method may provide an image sensor having high light-shielding efficiency in the optical black region and improved image quality.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
an active pixel sensor region configured to output a pixel signal for image generation; and
a periphery region at an edge of the active pixel sensor region,
wherein the active pixel sensor region and the periphery region comprise a sensor substrate, and the sensor substrate comprises a plurality of pixels arranged across the active pixel sensor region and the periphery region,
the active pixel sensor region comprises a plurality of nanostructures disposed to face the sensor substrate and spaced apart from the sensor substrate,
the periphery region comprises a light-shielding layer disposed on the sensor substrate and at the edge of the active pixel sensor region, and
the light-shielding layer comprises a light-reflective layer and a light-absorbing layer comprising an inorganic material.

2. The image sensor of claim 1, wherein a thickness of the light-absorbing layer ranges from 10 nm to 2 µm.

3. The image sensor of claim 1 or 2, wherein a density of the light-absorbing layer ranges from 2 g/cm³ to 3 g/cm³.

4. The image sensor of any preceding claim, wherein the light-absorbing layer comprises an a-CₓSi₍₁₋ₓ₎ alloy or a-CₓSi₍₁₋ₓ₎N.

5. The image sensor of claim 1, wherein the inorganic material is amorphous carbon, and the light-absorbing layer further comprises a dopant with which the amorphous carbon is doped.

6. The image sensor of any preceding claim, wherein the light-reflective layer and the light-absorbing layer are sequentially disposed on the sensor substrate, and optionally further comprising a planarization layer that is provided on the sensor substrate, extends from the active pixel sensor region to the periphery region, and covers the light-shielding layer.

7. The image sensor of claim 6, wherein the light-reflective layer is in direct contact with the light-absorbing layer.

8. The image sensor of claim 6 or 7, wherein the light-shielding layer further comprises an upper additional layer disposed on the light-absorbing layer and having a refractive index that is different from a refractive index of the planarization layer.

9. The image sensor of any of claims 6 to 8, wherein the light-shielding layer further comprises an intermediate additional layer disposed between the light-reflective layer and the light-absorbing layer and having a refractive index that is different from a refractive index of the light-absorbing layer.

10. The image sensor of any preceding claim, wherein the active pixel sensor region comprises the meta-optical element in which the plurality of nanostructures is positioned, and
wherein the active pixel sensor region further comprises a color filter array layer disposed between the sensor substrate and the meta-optical element, and optionally wherein the light-shielding layer further comprises a blue filter material layer disposed on the light-absorbing layer.

11. An electronic device comprising:
a lens assembly configured to form an optical image of an object; and
an image sensor according to any preceding claim configured to convert the optical image into an electrical signal

12. A method of manufacturing an image sensor, the method comprising:
forming a sensor substrate comprising a plurality of pixels configured to sense light;
setting regions of the sensor substrate as an active pixel sensor region and a periphery region at an edge of the active pixel sensor region, and forming a light-shielding layer comprising a light-reflective layer and a light-absorbing layer on the sensor substrate in the periphery region;
forming a planarization layer on the sensor substrate, the planarization layer extending from the active pixel sensor region to the periphery region and covering the light-shielding layer; and
forming a plurality of nanostructures on the planarization layer in the active pixel sensor region,
wherein the forming of the light-shielding layer comprises forming the light-reflective layer, and forming the light-absorbing layer comprising an inorganic material on the light-reflective layer.

13. The method of claim 12, wherein the forming of the light-shielding layer comprises:
forming the light-shielding layer on the sensor substrate across the active pixel sensor region and the periphery region; and
removing the light-shielding layer from the active pixel sensor region.

14. The method of claim 12 or 13, wherein the forming of the light-shielding layer further comprises annealing the light-absorbing layer after forming the light-absorbing layer.

15. The method of any of claims 12 to 14, wherein the forming of the light-absorbing layer is performed by plasma-enhanced chemical vapor deposition (PECVD), magnetron sputtering (MS), rotary target magnetron sputtering (RMS), or sputtering.
